# EUROPÄISCHE PATENTANMELDUNG

(11) **EP 4 814 515 A1**
(43) Veröffentlichungstag der Anmeldung: **30.09.2026**
(21) Anmeldenummer: 26157409.9
(22) Anmeldetag: 10.02.2026
(51) Int. Cl.: G01R 31/52, H02H 9/08

(54) **VERFAHREN ZUR SYMMETRIERUNG UND SYMMETRIERSCHALTUNG SOWIE ISOLATIONSÜBERWACHUNGSGERÄT FÜR EIN UNGEERDETES GLEICHSPANNUNGS-STROMVERSORGUNGSSYSTEM**

(30) Priorität: 24.02.2025 DE 102025106867
(71) Anmelder: Bender GmbH & Co. KG, 35305 Grünberg (DE)
(72) Erfinder: Hackl, Dieter, 35463 Fernwald (DE)
(74) Vertreter: advotec.

(57) **Zusammenfassung**

Die Erfindung betrifft ein Verfahren sowie eine Symmetrierschaltung (10) zur Symmetrierung eines ungeerdeten Gleichspannungs-Stromversorgungssystems (2). In einer Detektorschaltung (12) erfolgt ein Detektieren eines fehlerbehafteten aktiven Leiters (L-), in welchem aufgrund eines kleinsten Isolationswiderstands (Rf-) ein größter Ableitstrom gegen Erde (PE) fließt. Der fehlerbehaftete aktive Leiter (L-) wird mittels einer Schalteinrichtung (14) an die Symmetrierschaltung (10) angekoppelt, wobei der größte Ableitstrom mittels einer Steuer- und Regeleinrichtung (16) der Symmetrierschaltung (10) ohne Verringerung des Isolationswiderstands (Rf+) des anderen aktiven Leiters (L+) kompensiert wird. Des Weiteren betrifft die Erfindung ein erweitertes Isolationsüberwachungsgerät (30) für die Überwachung eines ungeerdeten Gleichspannungs-Stromversorgungssystems mit einer erfindungsgemäßen Symmetrierschaltung (10).

## Beschreibung

Die Erfindung betrifft ein Verfahren zur Symmetrierung und eine Symmetrierschaltung für ein ungeerdetes Gleichspannungs-Stromversorgungssystem, welches aktive Leiter aufweist, die jeweils einen Isolationswiderstand gegen Erde besitzen.

Weiterhin betrifft die Erfindung ein Isolationsüberwachungsgerät mit der erfindungsgemäßen Symmetrierschaltung.

Bei erhöhten Anforderungen an die Betriebs-, Brand-und Berührungssicherheit elektrischer Anlagen kommt die Netzform eines ungeerdeten Stromversorgungssystems zum Einsatz, die auch als isoliertes Netz (frz. "Isolé Terre" - IT-Netz) oder als IT-Stromversorgungssystem bezeichnet wird. Bei dieser Art des Stromversorgungssystems sind die aktiven Teile von dem Erdpotential - gegen Erde - getrennt. Die Körper der angeschlossenen elektrischen Verbraucher sind einzeln oder gemeinsam geerdet. Der Vorteil dieser Netze liegt darin, dass bei einem ersten Isolationsfehler die Funktion der angeschlossenen elektrischen Verbraucher nicht beeinträchtigt wird und somit trotz des fehlerhaften Zustands der Isolierung ein Weiterbetrieb möglich ist, da sich wegen des im Idealfall unendlich großen elektrischen Widerstands zwischen einem aktiven Leiter des Netzes und Erdpotential (Isolationswiderstand) kein geschlossener (Fehler-)Stromkreis ausbilden kann.

Im Rahmen dieser Erfindung wird unter dem Isolationswiderstand der ohmsche Anteil einer komplexen Isolationsimpedanz verstanden. Der über diesen Isolationswiderstand fließende ohmsche Stromanteil wird als Ableitstrom bezeichnet.

Da durch einen möglichen weiteren (Isolations-)Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte, muss der Isolationswiderstand des ungeerdeten Stromversorgungssystems ständig mit einem Isolationsüberwachungsgerät (IMD) überwacht werden.

Ungeerdete Stromversorgungssysteme werden daher überwiegend in Anwendungen eingesetzt, bei denen eine automatische Abschaltung der Stromversorgung bei Auftreten eines ersten Isolationsfehlers zu unerwünschten Risiken und Gefährdungen führen würde. Der Weiterbetrieb der Stromversorgung bis zur Beseitigung des Isolationsfehlers stellt somit eine vom Systembetreiber gewünschte und vorteilhafte Vorgehensweise dar.

Bei Auftreten eines ersten Isolationsfehlers kann bis zur Behebung des Isolationsfehlers an den angeschlossenen Betriebsmitteln eine Leiter-Erde-Spannung (Spannung zwischen einem der aktiven Leiter und Erde) in Höhe der Leiter-Leiter-Amplitude (Leiterspannung) auftreten. Diese Spannungsüberhöhung muss bei Betriebsmitteln, die in einem IT-System betrieben werden, bei der Isolationskoordination berücksichtigt werden.

Mit zunehmender Verbreitung von Gleichstrom-Stromversorgungssystemen mit der ungeerdeten Netzform IT-System gibt es jedoch zunehmend auch abweichende Anforderungen und Betriebsweisen.

So wird beispielsweise in industriellen Gleichstromsystemen gefordert, Betriebsmittel, die in geerdeten Stromversorgungssystemen gut verfügbar und kostengünstig einsetzbar sind, auch in Gleichstromsystemen mit der ungeerdeten Netzform IT-System unverändert einzusetzen. Im Falle eines dauerhaft unsymmetrischen Betriebs der ungeerdeten Stromversorgung gegenüber Erde könnten jedoch infolge der Spannungsverschiebung mit einer Verlagerungsspannung als vorzeichenbehaftete Spannungsdifferenz zur Mittelpunktspannung und der daraus resultierenden Spannungsüberhöhung an den einzelnen aktiven Leitern die Kriechstrecken der angeschlossenen Betriebsmittel überlastet werden und die Betriebsmittel könnten vorzeitig ausfallen.

Im Zuge der Hinwendung zur Elektromobilität kommt der elektrischen Sicherheit von DC-Ladestationen eine besondere Bedeutung zu. Bei dieser Anwendung handelt es sich oftmals um öffentlich zugängliche Stromversorgungen, die als IT-System mit hohen Spannungen und sehr hohen Leistungen betrieben werden. In der Produktnorm IEC 61581-23 werden daher im Rahmen der Schutzvorkehrungen gegen elektrischen Schlag auch der Fall des Berührens eines aktiven Leiters durch eine Person und die Entladung von Funkentstörkondensatoren über eine Person berücksichtigt. Da der Energieinhalt von Kondensatoren quadratisch mit der Spannung steigt, können in DC-Ladestationen größere Y-Funkentstörkondensatoren zum Einsatz kommen, wenn es gelingt, die Spannung an diesen Kondensatoren durch Symmetrierung des IT-Systems gegen Erde zu minimieren.

Nach bekanntem Stand der Technik erfolgt eine passive Symmetrierung in den Gleichstrom-IT-Systemen dadurch, dass ein Isolationsfehler des fehlerbehafteten aktiven Leiters gegen Erde durch eine gesteuerte oder geregelte ohmsche Ableitung des anderen (nicht fehlerbehafteten) aktiven Leiters, also des aktiven Leiters mit entgegengesetzter Polarität, gegen Erde so eingestellt wird, dass eine ausreichende Symmetrierung der Leiter-Erde-Spannungen erreicht wird.

So ist in der Patentschrift DE102018116055B3 ein Verfahren und Isolationswächter zur widerstandsadaptiven Isolierungsüberwachung gezeigt, mit dem eine Kombination aus Halbleiterschalter und Widerstand zu einem, über eine gewisse Integrationszeit beständigen, Ankoppelwiderstand moduliert wird und somit das Gleichspannungsnetz symmetriert werden kann.

Daneben wird nach heutigem Stand der Technik der Lösungsansatz verfolgt, das ungeerdet betriebene Gleichstromsystem bei ausreichend hochohmigem Isolationszustand aktiv zu symmetrieren oder im Falle eines ersten niederohmigen Fehlers, der mit den vorhandenen Maßnahmen nicht symmetriert werden kann, den fehlerhaften Zweig abzuschalten.

In der Offenlegungsschrift DE10 2018 211 625 A1 ist eine Bordnetzanordnung mit einer Symmetrieüberwachungseinrichtung für ein Kraftfahrzeug beschrieben, wobei in einer Ausgleichseinrichtung mit Stromquellen und veränderbaren Widerständen eine Symmetrie der Isolationswiderstände erreicht werden kann.

Weiter ist in der Offenlegungsschrift WO2023/007253A1 ein netzsymmetrierendes Isolationsüberwachungsgerät mit aktiver Spannungsunsymmetrie-Korrektur offenbart. Dabei werden analog steuerbare Spannungs- und Stromquellenschaltungen eingesetzt, die jedoch zu einer äußerst aufwendigen Schaltungsarchitektur führen.

In DC-Ladestationen besteht bei einer aktiven Symmetrierung, die nicht in ein Isolationsüberwachungssystem integriert ist, allerdings die Gefahr, dass der reduzierte Gesamt-Isolationswiderstand zu einer vorzeitigen Abschaltung der DC-Ladestation führt.

Bei einer aktiven Symmetrierung, die in ein Isolationsüberwachungssystem der DC-Ladestationen integriert ist, kann der reduzierte Gesamt-Isolationswiderstand im Berührungsfall zu einem erhöhten Körperstrom führen.

Der Stand der Technik bei ungeerdeten DC-IT-Systemen ist somit dadurch gekennzeichnet, dass eine ohmsche Ableitung an einem aktiven Leiter durch eine geeignete ohmsche Ableitung an dem aktiven Leiter mit entgegengesetzter Polarität gegen Erde eingebracht wird.

Bei ungeerdeten AC-IT-Systemen entspricht es dem Stand der Technik, ausreichend große und gleichmäßig über alle aktiven Leiter gegen Erde verteilte Netzableitkapazitäten im System vorzusehen.

Ein Nachteil der bekannten Verfahren ist die Verringerung des Gesamt-Isolationsniveaus (Gesamt-Isolationswiderstand) des ungeerdeten Gleichstromsystems gegen Erde. In industriellen ungeerdeten Gleichstromsystemen erhöht sich dadurch z.B. die Gefahr, dass korrosionswirksame Gleichstromableitungen auftreten und die Isolationsüberwachung negativ beeinflusst wird.

Auch bei ungeerdeten Wechselspannungs-Stromversorgungssystemen gibt es Anwendungen, bei denen ein symmetrischer Betrieb gegen Erde anzustreben ist. Bei Wechselspannungs-Stromversorgungssystemen mit größeren Netzableitkapazitäten wird die Symmetrierung gegen Erde allein durch gleichverteilte Netzableitkapazitäten erreicht. Anwendungsfälle, in denen dies nicht gewährleistet ist, können durch die vorliegende Erfindung abgedeckt werden.

Der vorliegenden Erfindung liegt somit die Aufgabe zugrunde, ein Verfahren sowie eine Schaltung zur Symmetrierung eines ungeerdeten Stromversorgungssystems, insbesondere eines Gleichspannungs-Stromversorgungssystems, zu konzipieren, wobei der Gesamt-Isolationswiderstand des ungeerdeten Stromversorgungssystems nicht verringert wird.

Diese Aufgabe wird durch ein Symmetrierverfahren mit den folgenden Verfahrensschritten gelöst: Detektieren eines fehlerbehafteten aktiven Leiters, in welchem aufgrund eines kleinsten Isolationswiderstands ein größter Ableitstrom gegen Erde fließt, Ankoppeln dieses fehlerbehafteten aktiven Leiters an eine Symmetrierschaltung, welche zwischen den fehlerbehafteten aktiven Leiter und Erde geschaltet wird, Kompensieren des größten Ableitstroms mittels einer Steuer- und Regeleinrichtung der Symmetrierschaltung, wobei der Isolationswiderstand des anderen aktiven Leiters nicht verringert wird.

Weiterhin wird die Aufgabe gelöst durch eine Symmetrierschaltung mit einer Detektorschaltung zum Detektieren eines fehlerbehafteten aktiven Leiters, in welchem aufgrund eines kleinsten Isolationswiderstands ein größter Ableitstrom gegen Erde fließt, einer Schalteinrichtung zum Ankoppeln dieses fehlerbehafteten aktiven Leiters an die Symmetrierschaltung, welche zwischen den fehlerbehafteten aktiven Leiter und Erde geschaltet wird, und einer Steuer- und Regeleinrichtung, die ausgelegt ist zur Kompensation des größten Ableitstroms, wobei der Isolationswiderstand des anderen aktiven Leiters nicht verringert wird.

Das beanspruchte Symmetrierverfahren basiert auf dem Grundgedanken, dass direkt an dem aktiven Leiter mit dem kleinsten Isolationswiderstand, also an dem Leiter, über den der größte Ableitstrom gegen Erde abfließt, kompensierend eingegriffen wird und somit dieser (größte) Ableitstrom an dem betreffenden aktiven Leiter ganz oder teilweise ausgeglichen wird, um die Leiter-Erde Spannungen der aktiven Leiter des IT-Systems möglichst symmetrisch gegen Erde einzustellen.

Nachdem der aktive Leiter mit dem kleinsten Isolationswiderstand mittels einer Detektorschaltung bestimmt und mittels einer Schalteinrichtung die Symmetrierschaltung zwischen den so bestimmten aktiven Leiter mit dem kleinsten Isolationswiderstand und Erde geschaltete wird, erfolgt die Kompensation des von dem betreffenden aktiven Leiter gegen Erde fließenden Ableitstroms durch eine Steuer- und Regeleinrichtung. Die Steuer- und Regeleinrichtung bildet den Hauptbestandteil der Symmetrierschaltung und weist ein steuerbares Bauelement, wie beispielsweise einen negativen Widerstand, eine spannungsgesteuerte Stromquelle, einen PWM-Signalgenerator oder einen Kompensationskondensator auf, um den Ableitstrom durch gesteuertes oder geregeltes Einstellen zu kompensieren.

Da im Gegensatz zum Stand der Technik zum Herstellen der Spannungssymmetrie der Ableitstrom des anderen aktiven Leiters gegen Erde nicht beeinflusst, insbesondere nicht erhöht wird, d.h. der Isolationswiderstand des anderen aktiven Leiters und somit auch der Gesamt-Isolationswiderstand des ungeerdeten Stromversorgungssystems nicht verringert wird, kann mit diesem Lösungsansatz in vorteilhafter Weise gleichzeitig sowohl die Spannungssymmetrie erreicht als auch der Gesamt-Isolationswiderstand erhöht werden.

In weiterer Ausgestaltung erfolgt das Detektieren des fehlerbehafteten aktiven Leiters mit dem kleinsten Isolationswiderstand durch Erfassen und Auswerten einer Verlagerungsspannung.

Das Auftreten eines Isolationsfehlers an einem der aktiven Leiter äußert sich in einer Spannungsunsymmetrie der Leiter-Erde-Spannungen (Spannung des jeweiligen aktiven Leiters gegen Erde). Es tritt eine Verlagerungsspannung auf, die nach Betrag und Vorzeichen erfasst und ausgewertet wird und daraus derjenige aktive Leiter mit dem kleinsten Isolationswiderstand (fehlerbehafteter aktiver Leiter) in einer Detektorschaltung bestimmt werden kann.

Alternativ zur Erfassung und Auswertung der Verlagerungsspannung kann das Detektieren des fehlerbehafteten aktiven Leiters mit dem kleinsten Isolationswiderstand durch Auswerten einer Information über die leiterbezogenen Isolationswiderstände erfolgen.

In Fällen, wo bereits eine Information über leiterbezogene, d.h. den einzelnen aktiven Leitern zugeordnete, Isolationswiderstände vorliegt - berechnet beispielsweise von einem Isolationsüberwachungsgerät oder mittels interner Berechnungen in der Symmetrierschaltung - wertet die Detektorschaltung die ihr übermittelten oder selbst berechneten leiterbezogenen Isolationswiderstände aus, um den aktiven Leiter mit dem kleinsten Isolationswiderstand zu bestimmen.

Bevorzugt erfolgt das Kompensieren des größten Ableitstroms in der Steuer- und Regeleinrichtung durch gesteuertes oder geregeltes Einstellen eines spannungsgesteuerten, elektronisch erzeugten negativen Widerstands.

In dieser Ausgestaltung weist die Steuer- und Regeleinrichtung als aktives Halbleiter-Bauelement einen spannungsgesteuerten negativen Widerstand auf, welcher den (kleinsten) Isolationswiderstand des fehlerbehafteten aktiven Leiters ausgleicht.

Alternativ erfolgt das Kompensieren des größten Ableitstroms in der Steuer- und Regeleinrichtung durch gesteuertes oder geregeltes Einstellen einer spannungsgesteuerten Stromquelle zur Erzeugung eines Kompensationsstroms gegenphasiger Polarität des größten Ableitstroms.

Der mittels der spannungsgesteuerten Stromquelle erzeugte gegenphasige Kompensationsstrom wirkt dem größten Ableitstrom entgegen, wobei sich in Verbindung mit der Steuerung oder Regelung die Spannungssymmetrie einstellt.

Als weitere Alternative erfolgt das Kompensieren des größten Ableitstroms in der Steuer- und Regeleinrichtung durch gesteuertes oder geregeltes Einstellen eines PWM-Signalgenerators zur digitalen Erzeugung eines PWM-Kompensations-Stromsignals mit gegenphasiger Polarität des größten Ableitstroms.

Gegenüber der zeitkontinuierlichen Einspeisung des Kompensationsstroms mittels der spannungsgesteuerten Stromquelle erfolgt die Kompensation des größten Ableitstroms in zeitdiskreter Form durch einen PWM-Signalgenerator, der ein PWM-Kompensations-Stromsignal mit gegenphasiger Polarität zum Ausgleichen des größten Ableitstroms erzeugt. Hier sind verschiedene energiesparende Schaltregler-Topologien, wie z.B. ein hochfrequent getakteter Sperrwandler, einsetzbar.

Auch kann das Kompensieren des größten Ableitstroms in der Steuer- und Regeleinrichtung durch gesteuertes oder geregeltes Einstellen eines Kompensationskondensators zum Einspeisen einer elektrischen Kondensatorladung gegenphasiger Polarität des größten Ableitstroms erfolgen.

Beispielhaft sei hier die zeitdiskrete Einspeisung von gegenphasiger Kondensatorladung, z.B. mit Hilfe von Schalterkondensator-Ladungspumpen, genannt.

Mit Vorteil erfolgt eine Begrenzung eines zwischen dem fehlerbehafteten aktiven Leiter und Erde fließenden Kompensationsstroms.

Überschreitet der für eine Symmetrierung zu erzeugende erforderliche Kompensationsstrom einen als kritisch anzusehenden Wert, so kann der tatsächlich erzeugte Kompensationsstrom auch bei fortschreitender Spannungsunsymmetrie durch eine Begrenzungsschaltung auf einen als unkritisch anzusehenden Wert begrenzt werden.

Weiterhin kann in kompensiertem Zustand eine Berechnung eines Kompensationswiderstands aus einer Leiter-Erde-Spannung des fehlerbehafteten aktiven Leiters und einem Kompensationsstrom sowie unter Einbeziehung einer Nennspannung und der Verlagerungsspannung eine Berechnung der leiterbezogenen Isolationswiderstände erfolgen.

Die Symmetrierschaltung kann somit dafür ausgelegt sein, neben der Symmetrierung gleichzeitig die Funktion eines Isolationsüberwachungsgerätes mit Bestimmung der leiterbezogenen Isolationswiderstände zu erfüllen.

Die in der erfindungsgemäßen Symmetrierschaltung beanspruchten strukturellen Komponenten führen die entsprechenden Verfahrensschritte des erfindungsgemäßen Verfahrens zur Symmetrierung des ungeerdeten Gleichspannungs-Stromversorgungssystems aus. Somit treffen die mit dem Symmetrierverfahren erzielten technischen Wirkungen und die daraus resultierenden Vorteile gleichermaßen auch auf die Symmetrierschaltung zu.

Mit der vorliegenden Erfindung gelingt die Symmetrierung der Leiter-Erde-Spannungen in einem ungeerdeten Gleichspannungs-Stromversorgungssystem durch vollständiges oder teilweises Kompensieren des (ohmschen) Ableitstroms gegen Erde an dem aktiven Leiter mit dem kleinsten Isolationswiderstand ohne dass der Isolationswiderstand des anderen Leiters verringert wird. Der Gesamt-Isolationswiderstand des ungeerdeten Gleichspannungs-Stromversorgungssystems wird somit in sicherheitstechnisch vorteilhafter Weise nicht verringert und kann durch die vorgeschlagenen Maßnahmen erhöht werden.

Sollen diese Maßnahmen der Symmetrierung von ungeerdeten Wechselspannungs-Stromversorgungssystemen dienen, so liegt auch hier der Schwerpunkt auf der Kompensation unsymmetrischer ohmscher Ableitungen gegen Erde. Die Kompensation unsymmetrischer kapazitiver Ableitströme wird in der Erfindung nicht betrachtet.

Die erfindungsgemäßen Symmetrierschaltung kann sowohl als eigenständige bauliche Einheit für die Ankopplung an ein ungeerdetes Gleichspannungs-Stromversorgungssystem verwendet werden, als auch in ein - vorzugsweise nach der Norm IEC 61557-8 ausgeführtes - erweitertes Isolationsüberwachungsgerät zu einer baulichen Einheit integriert werden.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein ungeerdetes Gleichspannungs-Stromversorgungssystem mit Isolationsüberwachung und erfindungsgemäßer Symmetrierschaltung,
- **Fig. 2:**: die Anordnung aus Fig. 1 mit Symmetrierschaltung im Detail,
- **Fig. 3:**: eine Simulationsanordnung zu Fig. 2 mit deaktivierter Symmetrierschaltung und Verwendung eines negativen Widerstands (Steuerung),
- **Fig. 4:**: eine Simulationsanordnung zu Fig. 2 mit aktivierter Symmetrierschaltung und Verwendung eines negativen Widerstands (Steuerung) und
- **Fig. 5:**: eine Simulationsanordnung zu Fig. 2 mit aktivierter Symmetrierschaltung und Verwendung eines negativen Widerstands (Regelung).

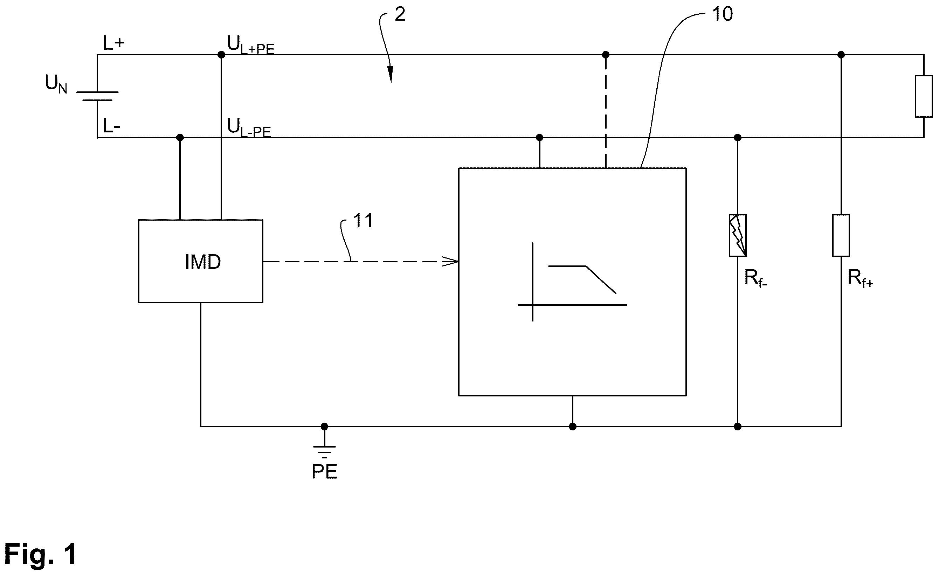

**Fig. 1** zeigt ein ungeerdetes Gleichspannungs-Stromversorgungssystem 2 mit zwei aktiven Leitern L+, L-, welches von der Nennspannung U_{N} gespeist und von einem Isolationsüberwachungsgerät IMD überwacht wird.

Die aktiven Leiter L+, L- führen gegen Erde PE die jeweiligen Leiter-Erde-Spannungen U_{L+PE}, U_{L-PE}, die bei symmetrische Belastung den gleichen Betrag aufweisen. Das Auftreten eines unsymmetrischen Isolationsfehlers, hier dargestellt durch den (kleinsten) Isolationswiderstand R_{f-} an dem negativen aktiven Leiter L-, führt zu einer Spannungsunsymmetrie zwischen den Leiter-Erde-Spannungen U_{L+PE}, U_{L-PE}. Zum Ausgleichen dieser Spannungsunsymmetrie wird die erfindungsgemäße Symmetrierschaltung 10 an denjenigen aktiven Leiter L+, L- angekoppelt, der den kleinsten Isolationswiderstand R_{f-} aufweist - vorliegend an den Leiter L- mit dem durch den widerstandsbehafteten Isolationsfehler bestimmten kleinsten Isolationswiderstand R_{f-}.

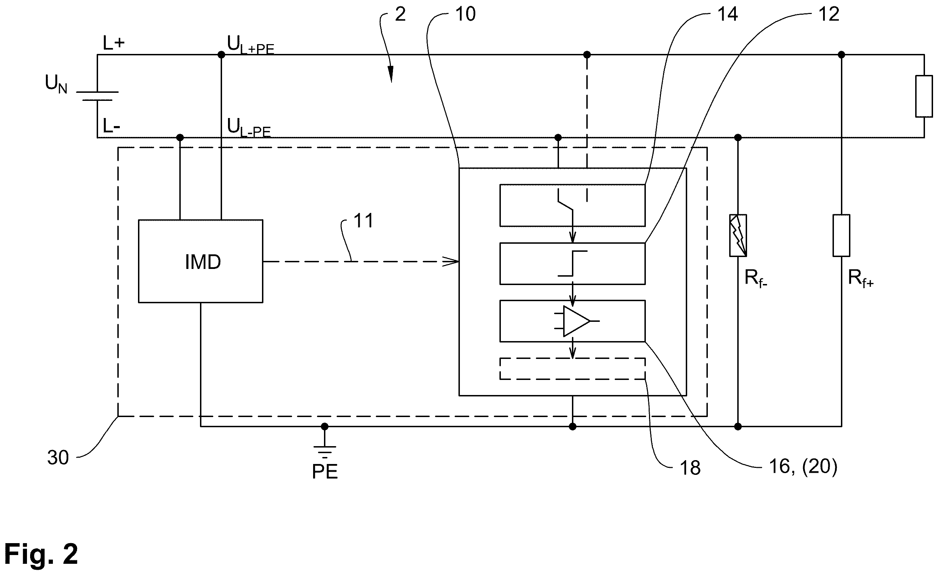

In **Fig. 2** ist die Anordnung aus Fig. 1 mit ungeerdetem Gleichspannungs-Stromversorgungssystem 2, Isolationsüberwachungsgerät IMD und der Symmetrierschaltung 10 im Detail dargestellt.

Die Symmetrierschaltung 10 umfasst eine Detektorschaltung 12, welche als Spannungsmess- und Auswerteeinrichtung ausgebildet ist und im Zusammenwirken mit einer Schalteinrichtung 14 eine Verlagerungsspannung erfasst. Die Verlagerungsspannung wird nach Betrag und Vorzeichen auswertet, um den fehlerbehafteten aktiven Leiter - vorliegend den Leiter L- mit dem (kleinsten) Isolationswiderstand R_{f-}, somit auch den Ableitungszweig mit dem größten Ableitstrom, zu detektieren.

Falls eine Information 11 über die Größe der leiterbezogenen Isolationswiderstände R_{f+}, R_{f-} bereits zur Verfügung steht - weil die leiterbezogenen Isolationswiderstände R_{f+}, R_{f-} beispielsweise in einem Isolationsüberwachungsgerät IMD ermittelt wurden - ist die Detektorschaltung 12 alternativ zur Ausführung als Spannungsmess- und Auswerteeinrichtung ausgelegt zum Auswerten einer vorliegenden Information 11 über die leiterbezogenen Isolationswiderstände R_{f+}, R_{f-}.

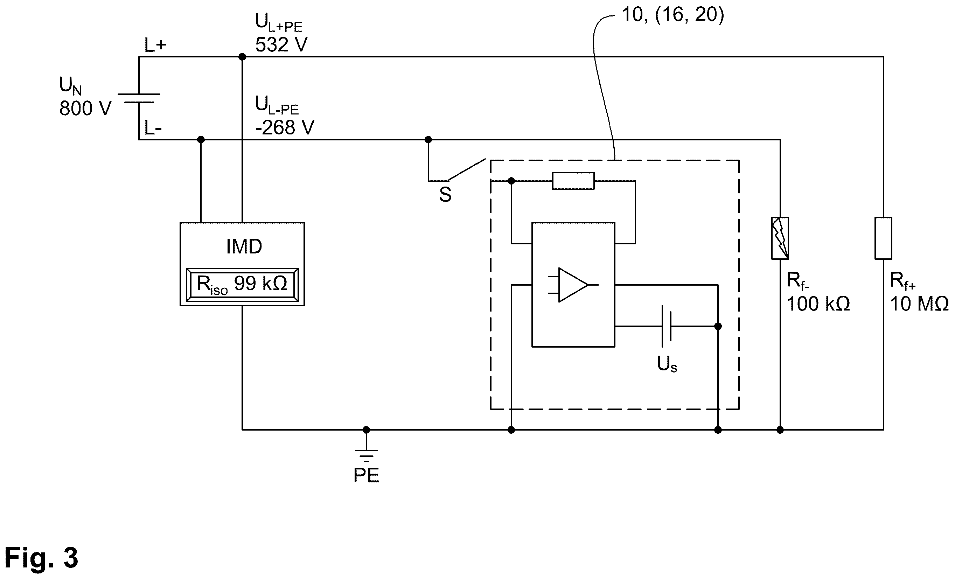

Wesentlicher Bestandteil der Symmetrierschaltung 10 bildet eine Steuer- und Regeleinrichtung 16, welche die eigentliche Kompensation des größten Ableitstroms und damit des kleinsten Isolationswiderstands R_{f-} durchführt. Die Steuer- und Regeleinrichtung 16 kann dazu jeweils alternativ einen negativen Widerstand 20 (Fig. 3), eine spannungsgesteuerte Stromquelle, einen PWM-Signalgenerator oder einen Kompensationskondensator aufweisen.

Die Symmetrierschaltung 10 kann weiter eine Begrenzungsschaltung 18 umfassen, die einen Kompensationsstrom Iₖ auf einen maximal zulässigen Wert begrenzt.

Auch kann in der Symmetrierschaltung 10 zusätzlich die Funktion der Isolationsüberwachung mitübernommen werden, indem in kompensiertem Zustand die Nennspannung U_{N}, die Verlagerungsspannung sowie der Kompensationsstrom Iₖ erfasst werden und daraus die leiterbezogenen Isolationswiderstände R_{f+}, R_{f-} berechnet werden. Ein eigenständiges Isolationsüberwachungsgerät IMD ist dann nicht erforderlich.

Anderseits kann die erfindungsgemäße Symmetrierschaltung 10 mit dem Isolationsüberwachungsgerät IMD zu einem erweiterten Isolationsüberwachungsgerät 30 in Form einer baulichen Einheit zusammengefasst werden.

Die folgenden Darstellungen in den **Fig. 3** bis **Fig. 5** veranschaulichen die Wirksamkeit des erfindungsgemäßen Symmetrierverfahrens und die Wirkungsweise der dieses Verfahren ausführenden erfindungsgemäßen Symmetrierschaltung anhand von Simulationen des isolationsüberwachten und zu symmetrierenden ungeerdeten Gleichspannungs-Stromversorgungssystems 2.

**Fig. 3** zeigt als Ausführungsbeispiel eine der Fig. 2 entsprechende Simulationsanordnung mit zunächst deaktivierter Symmetrierschaltung 10 unter Verwendung eines spannungsgesteuerten negativen Widerstands 20 in der Steuer- und Regeleinrichtung 16 der Symmetrierschaltung 10.

An dem aktiven Leiter L- (Minus-Leiter) liegt ein durch den (kleinsten) Isolationswiderstand R_{f-} = 100kΩ simulierter Isolationsfehler vor, wohingegen der andere aktive Leiter L+ (Plus-Leiter) einen unkritischen Isolationswiderstand R_{f+} = 10MΩ aufweist.

Bei deaktivierter Symmetrierschaltung 10 stellt sich ausgehend von einer Nennspannung U_{N}=800V infolge der unsymmetrischen Belastung an dem Plus-Leiter L+ eine Leiter-Erde-Spannung U_{L+PE} = 532V und an dem Minus-Leiter L- eine Leiter-Erde-Spannung U_{L-PE} = -268V ein. Die Verlagerungsspannung beträgt somit (betragsmäßig) 132V und kann in der praktischen Realisation nach Betrag und Vorzeichen durch eine als Spannungsmess- und Auswerteeinrichtung ausgebildete Detektorschaltung 12 zur Ermittlung des aktiven Leiters mit dem kleinsten Isolationswiderstand R_{f-} erfasst und ausgewertet werden.

Da die Simulation die Wirksamkeit der Kompensation in dem Ableitungszweig des kleinsten Isolationswiderstands R_{f-} zeigen soll, sind der fehlerbehaftete Minus-Leiter L- sowie im Sinne einer Steuerung die in der Simulation durch eine einstellbare Spannungsquelle realisierte Steuerspannung Uₛ des negativen Widerstands 20 vorgegeben. Dadurch entfällt in der Simulationsanordnung die Notwendigkeit der Detektorschaltung 12 (Fig. 2) und der Schalteinrichtung 14 (Fig. 2) - der Schalter S zum Aktivieren des spannungsgesteuerten negativen Widerstands 20 ist geöffnet.

In kompensierten Zustand mit einem spannungsgesteuerten negativen Widerstand 20 gilt für den Isolationswiderstand R_{f-} des Minus-Leiters L- und den Kompensationswiderstand R_{f-} = -Rₖₒₘₚ. Mit Bildung eines Spannungskoeffizienten Kᵤ aus der Verlagerungsspannung und der Nennspannung U_{N} kann der Isolationswiderstand R_{f+} des Plus-Leiters L+ berechnet werden zu R_{f+} = (R_{f-}/(1/2 Kᵤ)) - R_{f-}.

Das simulierte Isolationsüberwachungsgerät IMD ermittelt einen Gesamt-Isolationswiderstand Riso = 99kΩ. Dies entspricht korrekterweise der Parallelschaltung von R_{f-} = 100kΩ und R_{f+} = 100MΩ.

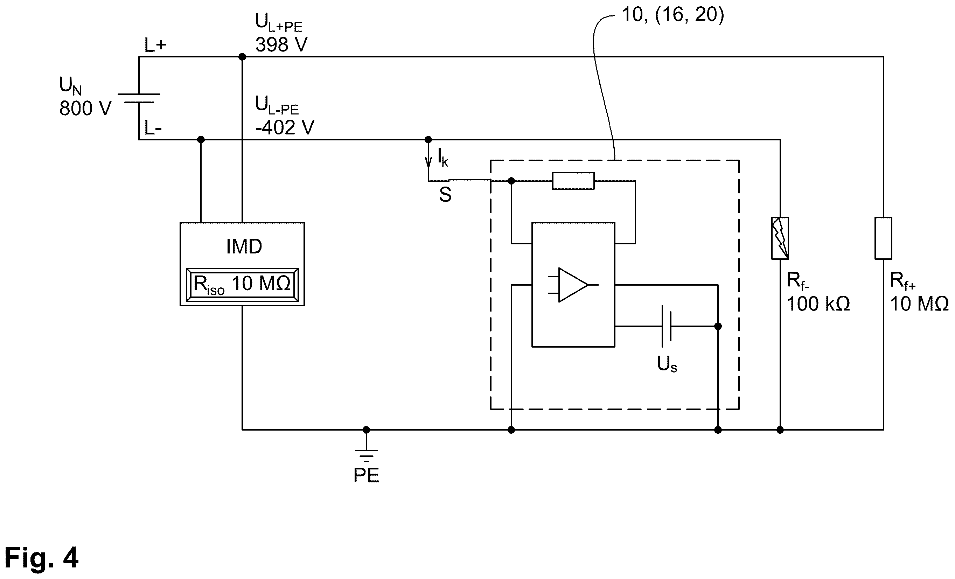

In **Fig. 4** ist der Schalter S zum Aktivieren des spannungsgesteuerten negativen Widerstands 20 geschlossen, sodass die Kompensation wirksam wird.

Es zeigt sich bei einer Verlagerungsspannung von (betragsmäßig) 2V eine nahezu vollständige Symmetrie der Leiter-Erde-Spannungen U_{L+PE} = 398V und U_{L-PE} = -402V.

Das simulierte Isolationsüberwachungsgerät IMD ermittelt einen Gesamt-Isolationswiderstand Riso = 10MΩ. Dies entspricht dem Isolationswiderstand von 10MΩ zwischen dem Plus-Leiter L+ und Erde PE.

Der Isolationsfehler R_{f-} = 100kΩ zwischen dem Minus-Leiter L- und Erde PE wird somit kompensiert.

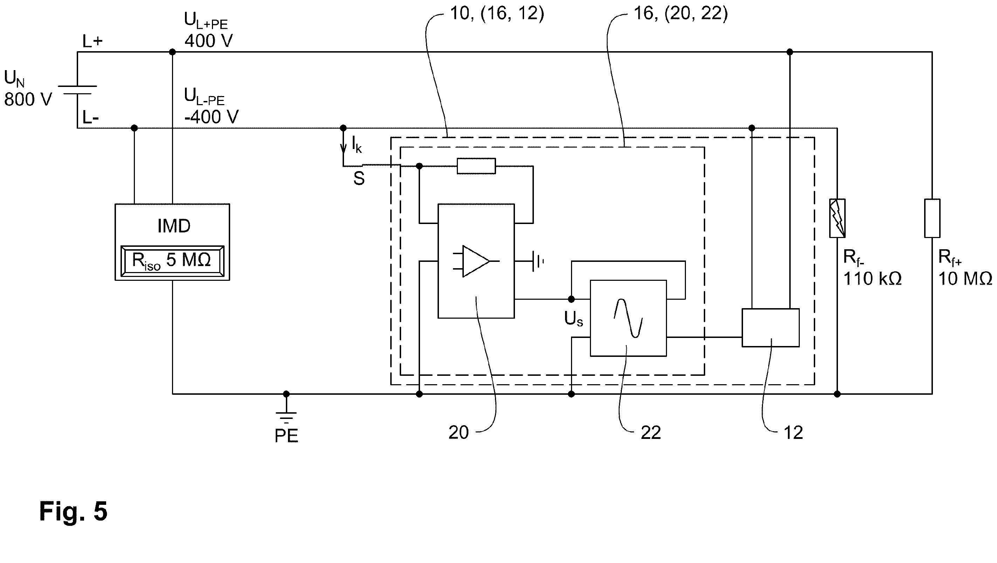

**Fig. 5** zeigt als weiteres Ausführungsbeispiel eine der Fig. 2 entsprechende Simulationsanordnung mit (aktiver) Symmetrierschaltung 10 in Form einer als Regelung ausgeführten Steuer- und Regeleinrichtung 16 mit einer als Spannungsmess- und Auswerteeinrichtung ausgeführten Detektorschaltung 12 zur Ermittlung der Verlagerungsspannung.

Die Steuer- und Regeleinrichtung 16 umfasst einen spannungsgesteuerten negativen Widerstand 20 sowie eine gesteuerte Spannungsquelle 22 zur Bereitstellung der Steuerspannung Uₛ für den spannungsgesteuerten negativen Widerstand 20. Die gesteuerte Spannungsquelle 22 empfängt die von der Detektorschaltung 12 ermittelte Verlagerungsspannung als Unsymmetrie-indizierende Eingangsgröße und stellt ausgangsseitig damit eine aus der Detektorschaltung 12 abgeleitete Steuerspannung Uₛ als Stellgröße für den Regelkreis bereit. Anstelle der in einer praktischen Ausführung vorhandenen Schalteinrichtung 14 ist die Ankopplung der Symmetrierschaltung 10 in der Simulation durch den geschlossenen Schalters S manuell vorgegeben. Der Isolationsfehler an dem Minus-Leiter L- ist durch den Isolationswiderstand R_{f-} = 110kΩ modelliert.

Mit der Regelung gelingt es, die Leiter-Erde-Spannungen U_{L+PE}, U_{L-PE} auf die Werte U_{L+PE} = 400V und U_{L-PE} = -400V automatisch zu symmetrieren.

Das simulierte Isolationsüberwachungsgerät IMD erfasst in diesem Fall einen nach außen wirksamen Gesamt-Isolationswiderstand von Rᵢₛₒ = 5MΩ.

## Patentansprüche

1. Verfahren zur Symmetrierung eines ungeerdeten Gleichspannungs-Stromversorgungssystems (2), welches aktive Leiter (L+, L-) aufweist, die jeweils einen Isolationswiderstand (R_{f+}, R_{f-}) gegen Erde (PE) besitzen, umfassend die Verfahrensschritte Detektieren eines fehlerbehafteten aktiven Leiters (L-), in welchem aufgrund eines kleinsten Isolationswiderstands (R_{f-}) ein größter Ableitstrom gegen Erde (PE) fließt,
Ankoppeln dieses fehlerbehafteten aktiven Leiters (L-) an eine Symmetrierschaltung (10), welche zwischen den fehlerbehafteten aktiven Leiter (L-) und Erde (PE) geschaltet wird,
Kompensieren des größten Ableitstroms mittels einer Steuer- und Regeleinrichtung (16) der Symmetrierschaltung (10), wobei der Isolationswiderstand (R_{f+}) des anderen aktiven Leiters (L+) nicht verringert wird.

2. Symmetrierverfahren nach Anspruch 1,
**dadurch gekennzeichnet,**
**dass** das Detektieren des fehlerbehafteten aktiven Leiters (L-) mit dem kleinsten Isolationswiderstand (R_{f-}) durch Erfassen und Auswerten einer Verlagerungsspannung erfolgt.

3. Symmetrierverfahren nach Anspruch 1,
**dadurch gekennzeichnet,**
**dass** das Detektieren des fehlerbehafteten aktiven Leiters (L-) mit dem kleinsten Isolationswiderstand (R_{f-}) durch Auswerten einer Information (11) über die leiterbezogenen Isolationswiderstände (R_{f+}, R_{f-}) erfolgt.

4. Symmetrierverfahren nach einem der Ansprüche 1 bis 3,
**dadurch gekennzeichnet,**
**dass** das Kompensieren des größten Ableitstroms in der Steuer- und Regeleinrichtung (16) durch gesteuertes oder geregeltes Einstellen eines spannungsgesteuerten, elektronisch erzeugten negativen Widerstands (20) erfolgt.

5. Symmetrierverfahren nach einem der Ansprüche 1 bis 3,
**dadurch gekennzeichnet,**
**dass** das Kompensieren des größten Ableitstroms in der Steuer- und Regeleinrichtung (16) durch gesteuertes oder geregeltes Einstellen einer spannungsgesteuerten Stromquelle zur Erzeugung eines Stromflusses mit gegenphasiger Polarität des größten Ableitstroms erfolgt.

6. Symmetrierverfahren nach einem der Ansprüche 1 bis 3,
**dadurch gekennzeichnet,**
**dass** das Kompensieren des größten Ableitstroms in der Steuer- und Regeleinrichtung (16) durch gesteuertes oder geregeltes Einstellen eines PWM-Signalgenerators zur digitalen Erzeugung eines PWM-Kompensations-Stromsignals mit gegenphasiger Polarität des größten Ableitstroms erfolgt.

7. Symmetrierverfahren nach einem der Ansprüche 1 bis 3,
**dadurch gekennzeichnet,**
**dass** das Kompensieren des größten Ableitstroms in der Steuer- und Regeleinrichtung durch gesteuertes oder geregeltes Einstellen eines Kompensationskondensators zum Einspeisen einer elektrischen Kondensatorladung mit gegenphasiger Polarität des größten Ableitstroms erfolgt.

8. Symmetrierverfahren nach einem der Ansprüche 1 bis 7,
**dadurch gekennzeichnet,**
**dass** eine Begrenzung eines zwischen dem fehlerbehafteten aktiven Leiter (L-) und Erde (PE) fließenden Kompensationsstroms (Iₖ) erfolgt.

9. Symmetrierverfahren nach einem der Ansprüche 2 bis 8,
**dadurch gekennzeichnet,**
**dass** in kompensiertem Zustand eine Berechnung eines Kompensationswiderstands R_{comp} aus einer Leiter-Erde-Spannung (U_{L-PE}) des fehlerbehafteten aktiven Leiters (L-) und einem Kompensationsstrom (Iₖ) sowie unter Einbeziehung einer Nennspannung (U_{N}) und der Verlagerungsspannung eine Berechnung der leiterbezogenen Isolationswiderstände (R_{f+}, R_{f-}) erfolgt.

10. Symmetrierschaltung (10) zur Symmetrierung eines ungeerdeten Gleichspannungs-Stromversorgungssystems (2), welches aktive Leiter (L+, L-) aufweist, die jeweils einen Isolationswiderstand (R_{f+}, R_{f-} ) gegen Erde besitzen,
**gekennzeichnet durch**
eine Detektorschaltung (12) zum Detektieren eines fehlerbehafteten aktiven Leiters (L-), in welchem aufgrund eines kleinsten Isolationswiderstands (R_{f-}) ein größter Ableitstrom gegen Erde (PE) fließt, eine Schalteinrichtung (14) zum Ankoppeln dieses fehlerbehafteten aktiven Leiters (L-) an die Symmetrierschaltung (10), welche zwischen den fehlerbehafteten aktiven Leiter (L-) und Erde (PE) geschaltet wird, und
eine Steuer- und Regeleinrichtung (16), die ausgelegt ist zur Kompensation des größten Ableitstroms, wobei der Isolationswiderstand (R_{f+}) des anderen aktiven Leiters (L+) nicht verringert wird.

11. Symmetrierschaltung (10) nach Anspruch 10,
**dadurch gekennzeichnet, dass**
die Detektorschaltung (12) als Spannungsmess- und Auswerteeinrichtung ausgebildet ist zum Erfassen und Auswerten einer Verlagerungsspannung.

12. Symmetrierschaltung (10) nach Anspruch 10,
**dadurch gekennzeichnet, dass**
die Detektorschaltung (12) ausgelegt ist zum Auswerten einer Information (11) über die leiterbezogenen Isolationswiderstände (R_{f+}, R_{f-}).

13. Symmetrierschaltung (10) nach einem der Ansprüche 10 bis 12,
**dadurch gekennzeichnet, dass**
die Steuer- und Regeleinrichtung (16) ausgeführt ist zur gesteuerten oder geregelten Einstellung eines spannungsgesteuerten ,elektronisch erzeugten negativen Widerstands (20).

14. Symmetrierschaltung (10) nach einem der Ansprüche 10 bis 12,
**dadurch gekennzeichnet, dass**
die Steuer- und Regeleinrichtung (16) ausgeführt ist zur gesteuerten oder geregelten Einstellung einer spannungsgesteuerten Stromquelle, um einen Stromfluss mit gegenphasiger Polarität des größten Ableitstroms zu erzeugen.

15. Symmetrierschaltung (10) nach einem der Ansprüche 10 bis 12,
**dadurch gekennzeichnet, dass**
die Steuer- und Regeleinrichtung (16) ausgeführt ist zur gesteuerten oder geregelten Einstellung eines PWM-Signalgenerators, um ein PWM-Kompensations-Stromsignal mit gegenphasiger Polarität des größten Ableitstroms zu erzeugen.

16. Symmetrierschaltung (10) nach einem der Ansprüche 10 bis 12,
**dadurch gekennzeichnet, dass**
die Steuer- und Regeleinrichtung (16) ausgeführt ist zur gesteuerten oder geregelten Einstellung eines Kompensationskondensators, um eine elektrischen Kondensatorladung mit gegenphasiger Polarität des größten Ableitstroms zu erzeugen.

17. Symmetrierschaltung (10) nach einem der Ansprüche 10 bis 16,
**gekennzeichnet durch**
eine Begrenzungsschaltung (18) zum Begrenzen eines zwischen dem fehlerbehafteten aktiven Leiter (L-) und Erde (PE) fließenden Kompensationsstroms (Iₖ) .

18. Symmetrierschaltung (10) nach einem der Ansprüche 10 bis 17,
**gekennzeichnet durch**
eine Auslegung zur Berechnung eines Kompensationswiderstands (Rₖₒₘₚ) aus einer Leiter-Erde-Spannung (U_{L-PE}) des fehlerbehafteten aktiven Leiters (L-) und einem Kompensationsstrom (Iₖ) sowie unter Einbeziehung einer Nennspannung (U_{N}) und der Verlagerungsspannung zu eine Berechnung der leiterbezogenen Isolationswiderstände (R_{f+}, R_{f-}) erfolgt in kompensiertem Zustand.

19. Symmetrierschaltung (10) nach einem der Ansprüche 10 bis 18,
**gekennzeichnet durch**
eine Ausführung als eigenständige bauliche Einheit.

20. Erweitertes Isolationsüberwachungsgerät (30) für die Überwachung eines ungeerdeten Gleichspannungs-Stromversorgungssystems, mit einem Isolationsüberwachungsgerät (IMD) und einer Symmetrierschaltung (10) nach einem der Ansprüche 10 bis 18, integriert in einer baulichen Einheit.
